(19) Europäisches Patentamt
European Patent Office
Office européen des brevets

(11) **EP 1 975 274 B1**

(12) **EUROPÄISCHE PATENTSCHRIFT**

(45) Veröffentlichungstag und Bekanntmachung des Hinweises auf die Patenterteilung:
**02.05.2012 Patentblatt 2012/18**

(21) Anmeldenummer: **08004813.5**

(22) Anmeldetag: **14.03.2008**

(51) Int Cl.:
*C23C 14/35* (2006.01)       *C23C 14/08* (2006.01)
*C23C 14/18* (2006.01)       *C03C 17/36* (2006.01)
*H01J 37/34* (2006.01)

(54) **Verfahren zur Herstellung eines wärmedämmenden, hoch transparenten Schichtsystems und mit diesem Verfahren hergestelltes Schichtsystem**

Method for manufacturing a heat insulated, highly transparent layer system and layer system produced according to this method

Procédé de fabrication d'un système de couche isolante très transparente et système de couche fabriqué à l'aide de celui-ci

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **14.03.2007 DE 102007012387**

(43) Veröffentlichungstag der Anmeldung:
**01.10.2008 Patentblatt 2008/40**

(73) Patentinhaber: **Fraunhofer-Gesellschaft zur Förderung der angewandten Forschung e.V. 80686 München (DE)**

(72) Erfinder:
• **Pflug, Andreas, Dipl.-Phys.**
  **38124 Braunschweig (DE)**
• **Szyszka, Bernd, Dr.**
  **38108 Braunschweig (DE)**
• **Ulrich, Stephan, Dr.**
  **38106 Braunschweig (DE)**
• **Boentoro, Tjhay-Weyna**
  **38106 Braunschweig (DE)**
• **Graf, Roman, Dr.**
  **4600 Olten (CH)**

(74) Vertreter: **Pfenning, Meinig & Partner GbR Patent- und Rechtsanwälte Theresienhöhe 13 80339 München (DE)**

(56) Entgegenhaltungen:
EP-A- 0 636 702          EP-A- 1 489 054
EP-B- 0 803 481          DE-A1- 3 543 178
DE-A1-102005 033 769     JP-A- 2006 206 424
US-A- 5 532 062          US-A- 6 045 626
US-A1- 2006 275 612

• CHRISTIE D J ET AL: "Power supply with arc handling for high peak power magnetron sputtering" JOURNAL OF VACUUM SCIENCE AND TECHNOLOGY: PART A, AVS /AIP, MELVILLE, NY, US, Bd. 22, Nr. 4, 1. Juli 2004 (2004-07-01), Seiten 1415-1419, XP012073747 ISSN: 0734-2101

## Beschreibung

Die Erfindung betrifft ein Verfahren zur Herstellung eines wärmedämmenden, hoch transparenten Schichtsystems auf einem transparenten Substrat, wie z.B. Architektur- oder Automobilglas. Die Erfindung betrifft außerdem ein mit diesem Verfahren hergestelltes Schichtsystem. Neben der Wärmedämmung kann das Schichtsystem auch die Funktion erfüllen, den Energieeintrag durch Sonnenstrahlung unter Beibehaltung einer hohen Transmission von sichtbarem Licht zu minimieren.

Aus dem Stand der Technik sind wärmedämmende, transparente Schichtsysteme bekannt, die im Wesentlichen aus einer alternierenden Folge von dielektrischen und metallischen Schichten bestehen. Die metallischen Schichten sind hierbei semi-transparent und werden durch die angrenzenden dielektrischen Schichten zusätzlich entspiegelt. Durch die elektrische Flächenleitfähigkeit der metallischen Schichten hat das Schichtsystem ein geringes Emissionsvermögen, wodurch es insbesondere für Wärmeisolierverglasungen geeignet ist. Hier kann der Wärmeverlust durch Strahlung durch das geringe Emissionsvermögen der Beschichtung minimiert werden.

Durch die Leitfähigkeit der metallischen Schichten kann das Schichtsystem außerdem eine hohe Selektivität haben. Die Selektivität ist hier als das Verhältnis von Lichttransmission zu Gesamtenergietransmission zu verstehen. Dadurch wird unter Beibehaltung einer hohen Lichttransmission im sichtbaren Wellenlängenbereich eine Überhitzung von mit derartig beschichtetem Glas ausgestatteten Gebäuden bei starker Sonneneinstrahlung verhindert.

Die DE 10 2005 033 769 A1 beschreibt ein Verfahren und eine Vorrichtung zur Mehrkathoden-PVD-Beschichtung und ein Substrat mit PVD-Beschichtung. Ein Teil der Kathoden werden hierbei nach der Magnetfeldunterstützten Hochleistungs-Impuls-Kathodenzerstäubung betrieben und die anderen Kathoden nach der Magnetfeld-unterstützten Kathodenzerstäubung mit Gleichstrom.

Die EP 0 636 702 A1 betrifft ein Verfahren zum Herstellen transparenter leitfähiger Filme, die im Wesentlichen aus einem durch Sputtern aufgetragenen Oxid bestehen. Es wird hier ein Sputtertarget verwendet, das zur Herstellung transparenter leitfähiger Filme geeignet ist.

Die US 2006/0275612 A1 betrifft ein mit einer dielektrischen Schicht beschichtetes Substrat, beispielsweise ein Glassubstrat. Die dielektrische Schicht wird durch Sputtern aufgetragen. Bevorzugt wird hierbei reaktives Sputtern in Gegenwart von Sauerstoff und/oder Stickstoff verwendet, wobei ein Ionenstrahl aus einer Ionenquelle eingesetzt wird.

Für die Anforderungen an Isolierverglasung ist u.a. die Norm "Berechnung des Wärmedurchgangskoeffizienten", DIN-EN 673 von Bedeutung. Doppelisolierverglasungen bestehen aus zwei Glasscheiben, die insgesamt vier Glasoberflächen aufweisen. Diese werden bezüglich eines Gebäudes von außen nach innen nummeriert und mit den Bezeichnungen "Position 1", ..., "Position 4" versehen. "Position 3" bezeichnet demnach die nach außen (bzw. in den Scheibenzwischenraum) gerichtete Seite der Innenscheibe einer Doppelverglasung. Der Norm kann entnommen werden, dass eine Doppelverglasung mit einem spezifischen Wärmedurchgangskoeffizienten von $U_g$=1,1 W/m$^2$K eine Beschichtung auf Position 3 mit einer Normal-Emissivität von 3,6 % oder weniger erfordert. Dies entspricht einem Schichtwiderstand der metallischen Schicht von $\leq$ 3,4 Ω.

Problematisch ist, dass in der industriellen Großflächenbeschichtung die Eigenschaften der metallischen Schichten häufig schlecht definiert sind, da diese stark von der Art, dem Alter und der Vorbehandlung des Substrats, der Reinigung sowie von Prozessparametern und ggf. von Eigenschaften weiter darunterliegender Schichten abhängen. Die spezifische Leitfähigkeit der Metallschichten für eine gegebene Schichtdicke ist daher in der Praxis oft nicht optimal und weist Schwankungen auf.

Zwischen dem elektrischen Widerstand dünner Metallschichten und der Emissivität besteht ein annähernd linearer Zusammenhang. Der elektrische Widerstand von Metallfilmen verhält sich reziprok zur Ladungsträgerkonzentration und -beweglichkeit sowie reziprok zur Schichtdicke. Die Emissivität kann daher reduziert werden, indem die Schichtdicke der Metallfilme vergrößert wird. Um die Anforderungen der Norm sicher zu erfüllen, werden daher in der Regel die Metallschichten mit höheren Schichtdicken aufgebracht, als dies bei einer optimalen und gut reproduzierbaren spezifischen Leitfähigkeit der Metallschichten erforderlich wäre. Die höheren Schichtdicken gehen jedoch zu Lasten der Transmission von sichtbarem Licht sowie des Spielraums bezüglich der Reflektionsfarbe.

Aufgabe der vorliegenden Erfindung ist es daher, ein Schichtsystem und ein Verfahren zu seiner Herstellung anzugeben, welches ein deutlich geringeres Emissionsvermögen als nach dem Stand der Technik hat, dessen Transmissivität für sichtbares Licht jedoch gegenüber dem Stand der Technik nicht verringert ist oder sogar verbessert ist.

Diese Aufgabe wird gelöst durch das Verfahren nach Anspruch 1 sowie dem Schichtsystem nach Anspruch 27. Vorteilhafte Weiterbildungen des erfindungsgemäßen Verfahrens und des erfindungsgemäßen Schichtsystems werden in den jeweiligen abhängigen Ansprüchen gegeben. Anspruch 35 gibt mögliche Verwendungen des erfindungsgemäßen Schichtsystems an.

Erfindungsgemäß wurde erkannt, dass eine Erhöhung der elektrischen Ladungsträgerbeweglichkeit in den leitfähigen Schichten eines Schichtsystems mit alternierend angeordneten leitfähigen und dielektrischen Schichten zu einer Verringerung der Emissivität unter Beibehaltung und sogar einer Verbesserung der Lichttransmission des Gesamtschichtsystems führt.

Erfindungsgemäß ist daher ein Schichtsystem, welches ein Substrat aufweist, auf dessen einer Oberfläche abwechselnd zumindest eine dielektrische Schicht und zumindest eine leitfähige Schicht angeordnet sind, wobei die zumindest eine dielektrische Schicht mit einer relaxierten Kristallphase mit einer scharf definierten Vorzugsrichtung vorliegt. Die leitfähigen Schichten sind metallische Schichten. Hierbei ist von Bedeutung, dass die spezifische Leitfähigkeit einer metallischen Schicht stark von der Güte ihrer Kristallstruktur abhängt und dass die Kristallstruktur der Metallschicht von der als Keimschicht fungierenden, unterhalb der Metallschicht befindlichen dielektrischen Schicht vorgegeben werden kann, wenn diese dielektrische Schicht in einer möglichst scharf definierten Vorzugsrichtung orientiert ist.

Zur messtechnischen Bestimmung des spezifischen Widerstands der infrarotreflektierenden Funktionsschichten, also der leitfähigen Schichten, wird zunächst der Flächenwiderstand $R_{sh}$ des Schichtsystems mit Hilfe des Vierpunkt-Verfahrens bestimmt. Das Vierpunktverfahren ist eine Methode zur Messung des Schichtwiderstands homogener Schichten ([Valdes, L.B., Resistivity Measurements on Germanium for Transistors, In: Proceedings of the IRE, February 1954, S. 420-427]). Hierzu wird die Oberfläche mit vier Elektroden (in einer äquidistanten Reihe) kontaktiert. Über die beiden äußeren Kontakte wird ein definierter Stromfluss I aufgebracht, zwischen den beiden inneren Kontakten wird die resultierende elektrische Spannung U gemessen. Sofern die Schichtdicke w deutlich kleiner als der Spitzenabstand s ist, ergibt sich daraus der Schichtwiderstand $R_{sh}$ als $R_{sh}=\pi/\ln(2)*U/I$. Der Vorteil dieses Verfahrens ist, dass die Spannungsmessung mit hoher Impedanz - d.h. annähernd stromlos - erfolgen kann und somit unabhängig von Kontaktwiderständen ist.

Alternativ kann ein kalibrierter, induktiver Leitfähigkeitssensor verwendet werden. Die Schichtdicke der infrarotreflektierenden Funktionsschicht kann mit Hilfe einer Elektronen-Mikrosonden-Analyse (EMA) bestimmt werden. Diese Methode liefert als primäre Messgröße die Massenbelegung des die leitfähige Schicht bildenden Metalls pro Flächeneinheit. Unter Zugrundelegung einer Dichte, die beispielsweise im Fall von Silber 10,5 g/cm$^3$ beträgt, ergibt sich hieraus eine effektive Schichtdicke $d_F$.

Erfindungsgemäß weisen also die metallischen Schichten des Schichtsystems eine optimierte und reproduzierbare spezifische Leitfähigkeit auf. Vorteilhafterweise beträgt der spezifische Widerstand für eine Schichtdicke von 12 nm weniger als 4,5 $\mu\Omega$cm, vorzugsweise weniger als 4,2 $\mu\Omega$cm und besonders bevorzugt weniger als 4,0 $\mu\Omega$cm. Die Flächenleitfähigkeit C, die als $C=1/R_{sh}$ definiert ist, verläuft für kleine Schichtdicken der metallischen Schicht annähern linear mit deren Schichtdicke. Für den Fall, dass die fragliche metallische Funktionsschicht eine andere Schichtdicke als 12 nm hat, ergibt sich messtechnisch die auf 12 nm bezogene, spezifische Leitfähigkeit aus einer linearen Extrapolation der Flächenleitfähigkeit C als Funktion der Schichtdicke für eine Schichtdicke von 12 nm. Hierbei werden mehrere gleichartige Schichtstrukturen mit unterschiedlichen Schichtdicken der metallischen infrarotreflektierenden Funktionsschichten gemessen. Es ist bevorzugt, wenn das Substrat des erfindungsgemäßen Schichtsystems transparent für sichtbares Licht ist. So kann das Substrat beispielsweise Floatglas und/oder Einscheibensicherheitsglas aufweisen oder daraus bestehen. Darüberhinaus kann das Substrat gebogen sein, was z.B. für Windschutzscheiben von Kraftfahrzeugen vorteilhaft ist.

Es ist bevorzugt, wenn das Schichtsystem auf die oben beschriebene Weise so eingestellt ist, dass die Reflektion und/oder die Transmission von elektromagnetischer Strahlung durch das Schichtsystem bei thermischer Nachbehandlung der beschichteten Scheibe und/oder einem Vorspannprozess $\Delta E:=(\Delta L^2+\Delta a^{*2}+\Delta b^{*2})^{1/2} < 3$ erfüllt, wobei $\Delta E$ die durch die thermische Nachbehandlung bzw. den Vorspannprozess hervorgerufene Farbwertänderung ist. So wird im sog. Vorspannungsprozess eine Glasscheibe zu Einscheiben-Sicherheitsglas transformiert, indem das Glas auf ca. 620 bis 720 °C aufgeheizt und anschließend schnell abgekühlt wird. Besonders bevorzugt ist $\Delta E<2$. Hierbei sind L, $a^*$ und $b^*$ Farbkoordinaten nach DIN 5033-3. Eine "farbstabile" Beschichtung ist hierbei also durch eine besonders geringe Farbänderung $\Delta E$ (vor und nach der thermischen Behandlung) gekennzeichnet. Die Farbstabilität kann durch Verwendung annähernd transparenter Blockerschichten für Silber erzielt werden.

Das erfindungsgemäße Schichtsystem ist u.a. für Scheiben, Verglasungen, Fensterscheiben und Automobilverglasungen verwendbar.

Wie beschrieben sollten die leitfähigen Schichten des erfindungsgemäßen Schichtsystems einerseits möglichst dünn sein, andererseits aber eine möglichst hohe Leitfähigkeit aufweisen. Sowohl Schichtdicken als auch Leitfähigkeiten sollten möglichst gut reproduzierbar sein. Wie bereits beschrieben, wird eine deutliche Erhöhung der Leitfähigkeit der leitfähigen Schichten dadurch erreicht, dass die Kristallstruktur der leitfähigen Schichten möglichst einheitlich orientiert ist. Im erfindungsgemäßen Verfahren zur Herstellung des oben beschriebenen Schichtsystems wird daher zumindest eine der dielektrischen Schichten, auf welchen die fragliche Metallschicht aufgebracht wird, mittels eines Niederdruck-Plasma-Beschichtungsverfahrens hergestellt. Hierbei ist ein besonders geeignetes und daher bevorzugtes Beschichtungsverfahren das Hochleistungs-Pulssputter-Verfahren.

Im erfindungsgemäßen Verfahren zur Herstellung eines wärmedämmenden und transparenten Schichtsystems wird also alternierend auf ein Substrat zumindest eine dielektrische Schicht und zumindest eine leitfähige, metallische, Schicht aufgebracht, wobei zumindest eine der zumindest einen dielektrischen Schichten mittels eines Niederdruck-Plasma-Beschichtungsverfahrens, mittels Hochleistungs-Pulssputtern, aufgebracht wird.

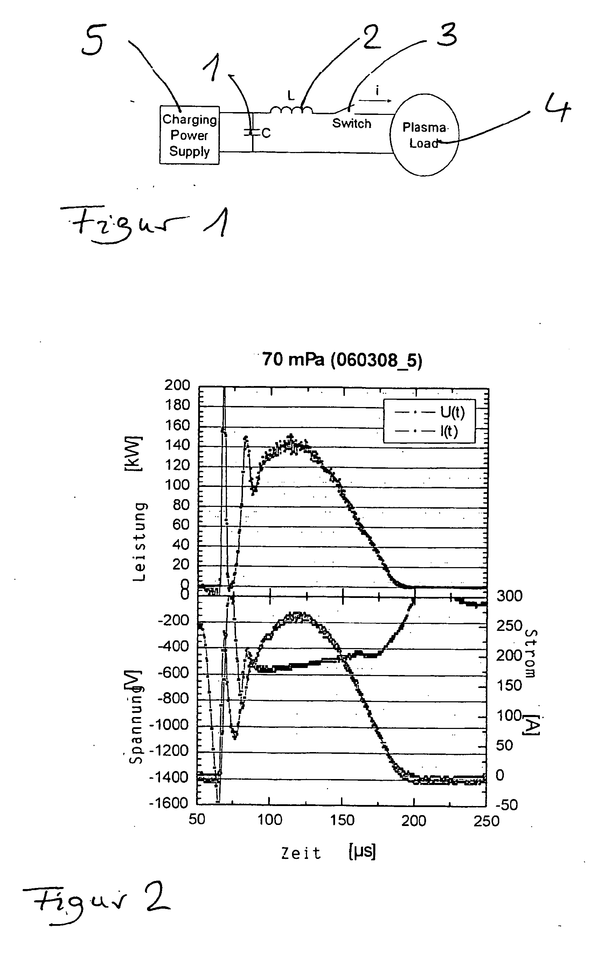

Das Prinzip des Hochleistungs-Pulssputter-Verfahrens wird in D.J. Christie et al., "Power Supply with Arc Handling for High-Peak Power Magnetron Sputtering" in J. Vac. Sci. Technol. A22 (4) (2004), S. 1415-9 beschrieben. Die Technologie ist auch als High-Pulse-Power-Magnetron-Sputtering-Verfahren bekannt. Figur 1 zeigt einen Generator zur Erzeugung eines Plasmas für diese Sputtertechnologie. Hierbei wird eine Kondensatorbank 1 (C), die zur Ladungsspannungsquelle parallel geschaltet ist, geladen und die resultierende Spannung über eine Spule 2 (L) und einen mit dieser in Reihe geschalteten Schalter 3 an ein Plasma 4 angelegt. Das Plasma 4 ist parallel zum Kondensator geschaltet. Es kommt zur Entladung und zur Ausbildung eines Pulses. Die mit "plasma load" bezeichneten Ausgänge 4 werden an ein Sputtertarget angeschlossen.

Die wichtigsten Kenn- und Stellgrößen des Generators sind die Ladungsspannung $U_C$, die Kapazität C und die Frequenz f. Für den Energieinhalt $E_{pulse}$ des Pulses, die Pulsdauer $\tau_{pulse}$ und die mittlere Leistung $P_{avg}$ ergibt sich daraus

$$E_{pulse} = \frac{1}{2} C \cdot U_C{}^2$$

$$\tau_{pulse} \sim 3\sqrt{C \cdot L}$$

$$P_{avg} = f \cdot \frac{1}{2} C \cdot U_C{}^2$$

Mit Hilfe einer Frequenzregelung ist es hierbei möglich, den Reaktivgaspartialdruck beim reaktiven Sputtern zu regeln (F. Ruske, A. Pflug, V. Sittinger, W. Werner, B. Szyszka, D.J. Christie: Reactive deposition of Al-doped ZnO thin films using high power pulsed magnetron sputtering (HPPMS); Proceeding of the 6th ICCG, Dresden 2006, noch nicht veröffentlicht).

Bei einer Ladespannung von größer oder gleich 800 V tritt eine signifikante Änderung der Orientierung ein. Bei oberhalb oder gleich 1000 V geht dieser Effekt in Sättigung.

Das Verfahren wird so ausgeführt, dass zumindest eine der zumindest einen dielektrischen Schichten in einer relaxierten Kristallphase mit einer scharf definierten Vorzugsrichtung aufgebracht wird. Die Kristallstruktur kann durch Röntgenbeugungsmessungen in der Bragg-Brentano-Geometrie (θ-2θ) anhand des (002)-Reflexes quantifiziert werden. Dieser Reflex tritt für einen unverspannten, idealen Kristall bei θ =34,4° auf. Gesputterte Materialien weisen eine mehr oder weniger starke Schichtspannung auf, die sich in einer Verschiebung des Reflexionspeaks zu kleineren Winkeln hin (entsprechend grö-βeren Gitterkonstanten) bemerkbar macht. Der Grad an Kristallorientierung kann anhand der Fläche unter dem Peak des (002)-Reflexes bestimmt und quantifiziert werden. In der θ-2θ-Geometrie tragen nur diejenigen Kristallkörner zum Beugungsreflex bei, die annähern parallel zur Oberfläche orientiert sind.

Erfindungsgemäß beträgt die mittlere Fehlorientierung der Körner weniger oder gleich 5°. Bei einer Θ-2Θ-Messung geht die XRD-Peakintensität des Ag(111)-Reflexes bei einer Fehlorientierung von mehr als 5° nahezu vollständig verloren. Besonders bevorzugt ist eine mittlere Fehlorientierung von weniger oder gleich 3°, besonders bevorzugt weniger oder gleich 2°. Die Fehlorientierung kann mit Röntgenbeugung mit sog. Rockingkurven (d.h. mittel Verkippung der Probe) anhand des Intensitätsverlaufs wiedergegeben werden.

Es ist bevorzugt, wenn zumindest eine der zumindest einen metallischen Schichten eine infrarotreflektierende Schicht ist.

Vorteilhaft am erfindungsgemäß eingesetzten High-Peak-Power-Magnetron-Sputtering-Verfahren ist der hohe Ionisierungsgrad der gesputterten Spezies. Dieser beträgt erfindungsgemäß vorteilhafterweise mehr als 50 %, vorzugsweise mehr als 60 %, vorzugsweise mehr als 70 %, vorzugsweise mehr als 80 %, besonders bevorzugt mehr als 90 %.

Darüberhinaus ist vorteilhaft, dass in diesem Verfahren die gesputterten Teilchen mit einer Ionisierungsenergie von typischerweise über 10 eV auf das Schichtsystem auftreffen. Das gesputterte Material trifft also vorzugsweise mit einer Energie von mehr als 10 eV, vorzugsweise von mehr als 12 eV, vorzugsweise von mehr als 15 eV pro Teilchen auf das Schichtsystem auf. Dies führt, insbesondere im Zusammenhang mit geeigneten Materialien, zur Ausbildung einer relaxierten Kristallphase mit einer scharf definierten Vorzugsorientierung. Diese kann dann als Keimschicht für das kristalline Wachstum der darauffolgend aufgebrachten metallischen, infrarotreflektierenden Funktionsschicht dienen.

Als Material für die metallischen Schichten ist Silber besonders bevorzugt. Die dielektrischen Schichten weisen vorzugsweise Zinkoxid auf oder bestehen daraus. Besonders bevorzugt ist es, wenn zumindest eine der zumindest einen dielektrischen Schichten mit einer Dotierkomponente, wie z.B. Aluminium, dotiert wird. Hierdurch wird erreicht, dass die dielektrische Schicht nicht völlig isolierend ist, so dass der Sputterprozess weniger durch kleine Bogenentladungen (sog. "Arcing") aufgrund von Oberflächenaufladungen gestört wird.

Für das erfindungsgemäße Verfahren ist es besonders bevorzugt, wenn zumindest eine der zumindest einen dielektrischen Schichten reaktiv von einem metallischen Zink-Target gesputtert wird. Hierbei kann das Zink-Target eine Dotierkomponente aufweisen, so dass die entstehende dielektrische Schicht dotiert ist. Möglich ist auch, dass zumindest eine der zumindest einen dielektrischen Schichten von einem keramischen Zinkoxid-Target gesputtert wird. Auch dieses keramische Zinkoxid-Target kann eine Dotierkomponente aufweisen.

Vorzugsweise hat eine, mehrere oder alle der metallischen Schichten eine Schichtdicke ≤ 20 nm, vorzugsweise ≤ 17 nm, vorzugsweise ≤ 15 nm, vorzugsweise ≤ 14 nm, vorzugsweise ≤ 12 nm. Bevorzugt ist außerdem, wenn die Schichtdicke dieser Schichten ≥ 9 nm, vorzugsweise ≥ 10 nm, vorzugsweise ≥ 11 nm ist.

Während einer länger andauernden Produktion in einer industriellen Magnetron-Sputteranlage kommt es zur Redeposition des gesputterten Materials auf dem Sputtertarget sowie auf Blenden in der Umgebung des Targets. Hierdurch wird die Standzeit der Produktionsanlage limitiert, da sich die hierdurch entstehende Schicht auf einer bestimmten Schichtdicke in Form von Staubpartikeln ablöst. Dies hat eine erhöhte Defektdichte auf dem beschichteten Substrat zur Folge. Zur Umgehung dieses Problems hat es sich als besonders vorteilhaft erwiesen, die Magnetron-Sputterquellen mit einer Vorrichtung zu versehen, mit deren Hilfe die Sputtertargets im Vakuum von redeponiertem Material gereinigt werden können ohne dass ein Belüften der Anlage erforderlich wird. Eine solche Vorrichtung kann besonders vorteilhaft eine Drahtbürste aufweisen, die mit Hilfe einer Antriebsvorrichtung im Vakuum über die Redepositionszonen bewegt werden kann. Durch eine solche Reinigung werden die Standzeit und die Reproduzierbarkeit der Performance des Schichtsystems weiter verbessert.

Das Substrat kann vorgespannt werden und anschließend derart abgekühlt werden, dass es sich in Einscheibensicherheitsglas transformiert. Hierzu kann das Substrat beispielsweise zum Vorspannen für einen Zeitraum von 5 bis 15 min. auf 600 bis 700 °C erhitzt werden. Zur Herstellung eines gebogenen Substrats kann das Substrat während des Vorspannens gebogen werden. Vorzugsweise wird das Verfahren hierbei so ausgeführt, dass sich die spezifische Leitfähigkeit des Schichtsystems und/oder der leitfähigen Schichten beim Vorspannen um weniger als 10 %, vorzugsweise um weniger als 5 % ändert.

Im erfindungsgemäßen Verfahren können die metallischen Funktionsschichten vor Schäden durch nachfolgende Prozessschritte geschützt werden, indem für Blockerschichten geeignete Materialien, wie beispielsweise $NbN_xO_y$ und/oder ZnO:Al und/oder $NiCrO_x$ verwendet werden. Für die dielektrischen Schichten ist es möglich, ein Schichtsystem herzustellen, welches einem Vorspann- und/oder Wegeprozess des zu beschichtenden Glassubstrats bei Temperaturen größer oder gleich 500 °C, vorzugsweise größer oder gleich 600 °C und/oder kleiner oder gleich 1000°C, vorzugsweise kleiner oder gleich 800 °C, vorzugsweise zwischen 620 und 720 °C standhält. Hierdurch können beschichtete Bandmaß-Substrate durch nachträgliche Temperaturbehandlung in beschichtete, gebogene oder gehärtete Scheiben transformiert werden. Die oben genannte geringe Änderung der spezifischen Leitfähigkeit beim Biege- bzw. Vorspannprozess resultiert aus der bereits annähern optimalen Leitfähigkeit der metallischen Funktionsschichten vor der thermischen Nachbehandlung und hat zur Folge, dass derartige Schichtsysteme sich beim thermischen Vorspannen bzw. Biegen auch hinsichtlich ihrer optischen Eigenschaften äußerst stabil verhalten.

Im Folgenden soll die Erfindung anhand von Beispielen erläutert werden. Es zeigt

Figur 1    einen High-Pulse-Power-Magnetron-Sputterin-Generator, der im erfindungsgemäßen Verfahren zur Anwendung kommt,

Figur 2    den Verlauf der Leistung, des Stroms und der Spannung eines typischen HPPMS-Pulses,

Figur 3    den $O_2$-Partialdruck in mPa in Abhängigkeit von der Frequenz in Hz bei einer Ladungsspannung $U_c = 800$ V,

Figur 4    die Abhängigkeit des ZnO (002)-Reflexes von der Ladungsspannung (Charge Voltage) beim HPPMS-Sputtern von keramischen $ZnO:Al_2O_3$-Targets, und

Figur 5    die Abhängigkeit des (002)-Reflexes von der Entladungsspannung beim HPPMS-Verfahren beim reaktiven Sputtern metallischer Zn:Al-Targets.

Figur 2 zeigt einen Entladungspuls, wie er in dem in Figur 1 gezeigten Generator erzeugt wird. Der obere Teil der Figur zeigt hierbei den Leistungsverlauf unabhängig von der Zeit, während der untere Teil den Verlauf von Strom und Spannung mit der Zeit darstellt. Im unteren Teil ist die schwarze Kurve die Spannung $U_t$ und die graue Kurve der Strom I(t). Die anfänglichen Oszillationen der Spannung und des Stroms sind hierbei durch die C·L-Kombination in Verbindung mit der Plasmaimpedanz bedingt.

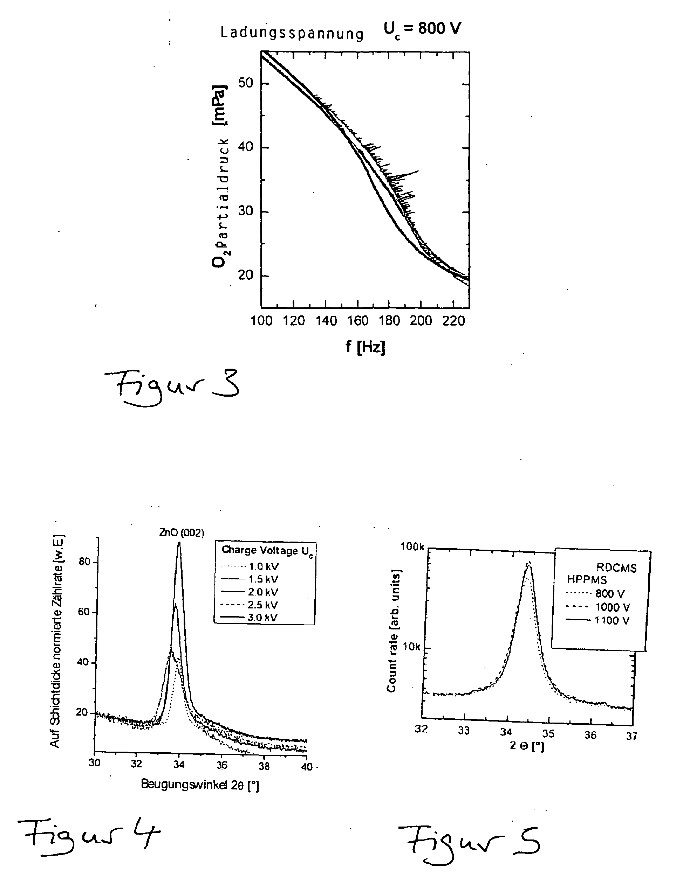

Figur 3 zeigt eine geregelte Prozesskennlinie eines reaktiven Sputterprozesses mit einem Zn:Al (1 Gew.-%)-Target. Weitere Details zu diesem HPPMS-Prozess finden sich in Christie, D.J.; Tomasel, F.; Sproul, W.D.; Carter, D.C.: Power supply with arc handling for high peak power magnetron sputtering, In: J: Va. Sci. Technol. A 22/4 (2004) 1415-9, und Christie, D.J.; Pflug, A.; Sittinger, V.; Ruske, F.; Siemers, M.; Szyszka, B.; Geisler, M.: Model prediction and Empirical Conformation of Rate Scaling with Peak Power for High Power Pulse Magnetron Sputtering (HPPMS) Deposition of Thin Ag Films, In: Proc. 48th SVC Tech. Conf. (2005) 501-3.

Figur 4 zeigt, dass für ein Sputtern keramischer $ZnO:Al_2O_3$-Targets, das sowohl die Peak-Fläche als auch die Lage des (002)-Peaks der ZnO-Struktur durch Wahl der HPPMS-Parameter beeinflusst werden kann. Eine hohe Ladungsspannung (Charge-Voltage) wirkt sich tendenziell positiv auf die Kristalltextur aus. Noch eindeutigere Ergebnisse ergeben sich beim reaktiven HPPMS-Sputtern mit metallischen Zn:Al-Targets, wie es in Figur 5 gezeigt ist.

Die in Figur 4 verwendeten Prozessparameter waren die folgenden:

| | |
|---|---|
| Targetmaterial: | Keramisches $ZnO:Al_2O_3$ (1,0 Gew.-%) |
| Ar-Fluss: | 200 sccm |
| Prozessdruck: | 670 mPa (im Bereich des Sputtertargets) |
| Pulszeit: | 100 $\mu$s |
| Frequenz: | 250 Hz |
| Charge Voltage: | 1,0 ... 3,0 kV |

Figur 5 zeigt die Abhängigkeit des (002)-Reflexes von der Entladungsspannung beim HPPMS-Verfahren beim reaktiven Sputtern metallischer Zn:Al-Targets. Die Figur entstammt F. Ruske et al.; Thin Solid Films (2007), doi: 10.1016/j.tsf.2007.06.19.

**Patentansprüche**

1. Verfahren zur Herstellung eines wärmedämmenden und transparenten Schichtsystems, wobei alternierend auf ein transparentes Substrat zumindest eine dielektrische Schicht und zumindest eine metallische Schicht aufgebracht wird,
**dadurch gekennzeichnet, dass**
die zumindest eine dielektrische Schicht mittels Hochleistungs-Pulssputtern aufgebracht wird, und
dass zumindest eine der zumindest einen dielektrischen Schichten in einer relaxierten Kristallphase mit einer scharf definierten Vorzugsrichtung aufgebracht wird,
wobei eine mittlere Fehlorientierung der Körner gegenüber der Vorzugsrichtung ≤ 5° ist.

2. Verfahren nach dem vorhergehenden Anspruch, **dadurch gekennzeichnet, dass** die mittlere Fehlorientierung der Körner gegenüber der Vorzugsrichtung ≤ 4°, vorzugsweise ≤ 3° ist.

3. Verfahren nach einem der vorhergehenden Ansprüche, **dadurch gekennzeichnet, dass** als zumindest eine metallische Schicht eine infrarotreflektierende Schicht aufgebracht wird.

4. Verfahren nach einem der vorhergehenden Ansprüche, **dadurch gekennzeichnet, dass** zumindest eine dielektrische Schicht durch Magnetron-Sputtern aufgebracht wird.

5. Verfahren nach einem der vorhergehenden Ansprüche, **dadurch gekennzeichnet, dass** das gesputterte Material bei einem Ionisierungsgrad von > 50 %, vorzugsweise > 60 %, vorzugsweise > 70 %, vorzugsweise > 80 %, vorzugsweise > 90 % aufgebracht wird.

6. Verfahren nach einem der vorhergehenden Ansprüche, **dadurch gekennzeichnet, dass** das gesputterte Material mit einer Energie von mehr als 10 eV, vorzugsweise von mehr als 12 eV, vorzugsweise von mehr als 15 eV pro Teilchen auf dem Schichtsystem auftrifft.

7. Verfahren nach einem der vorhergehenden Ansprüche, **dadurch gekennzeichnet, dass** das Substrat transparent ist und/oder Floatglas aufweist oder daraus besteht.

8. Verfahren nach einem der vorhergehenden Ansprüche, **dadurch gekennzeichnet, dass** das Substrat nach dem Aufbringen der Schichten vorgespannt wird und anschließend derart abgekühlt wird, dass es sich in Einscheibensicherheitsglas transformiert.

9. Verfahren nach dem vorhergehenden Anspruch, **dadurch gekennzeichnet, dass** das Substrat zum Vorspannen für einen Zeitraum von 5 bis 15 min auf 600 bis 700 °C erhitzt wird.

10. Verfahren nach einem der beiden vorhergehenden Ansprüche, **dadurch gekennzeichnet, dass** das Substrat während des Vorspannens gebogen wird.

11. Verfahren nach einem der drei vorhergehenden Ansprüche, **dadurch gekennzeichnet, dass** sich die spezifische Leitfähigkeit des Schichtsystems beim Vorspannen um weniger als 10 %, vorzugsweise um weniger als 5 % ändert.

12. Verfahren nach einem der vorhergehenden Ansprüche, **dadurch gekennzeichnet, dass** beim Aufbringen zumindest einer der mindestens einen metallischen Schichten Silber aufgebracht wird.

13. Verfahren nach einem der vorhergehenden Ansprüche, **dadurch gekennzeichnet, dass** beim Aufbringen zumindest einer der zumindest einen dielektrischen Schichten Zinkoxid aufgebracht wird.

14. Verfahren nach einem der vorhergehenden Ansprüche, **dadurch gekennzeichnet, dass** zumindest eine der zumindest einen dielektrischen Schichten mit einer Dotierkomponente dotiert wird.

15. Verfahren nach dem vorhergehenden Anspruch, **dadurch gekennzeichnet, dass** die Dotierkomponente Aluminium ist.

16. Verfahren nach einem der vorhergehenden Ansprüche, **dadurch gekennzeichnet, dass** zumindest eine der zumindest einen dielektrischen Schichten reaktiv von einem metallischen Zink-Target gesputtert wird.

17. Verfahren nach dem vorhergehenden Anspruch, **dadurch gekennzeichnet, dass** das Zink-Target eine Dotierkomponente aufweist.

18. Verfahren nach einem der vorhergehenden Ansprüche, **dadurch gekennzeichnet, dass** zumindest eine der zumindest einen dielektrischen Schichten von einem keramischen Zinkoxid-Target gesputtert wird.

19. Verfahren nach dem vorhergehenden Anspruch, **dadurch gekennzeichnet, dass** das keramische Zinkoxid-Target eine Dotierkomponente aufweist.

20. Verfahren nach einem der vorhergehenden Ansprüche, **dadurch gekennzeichnet, dass** zumindest eine der zumindest einen metallischen Schichten mit einer Schichtdicke größer oder gleich 9 nm, vorzugsweise größer oder gleich 10 nm, vorzugsweise größer oder gleich 11 nm aufgebracht wird.

21. Verfahren nach einem der vorhergehenden Ansprüche, **dadurch gekennzeichnet, dass** zumindest eine der zumindest einen metallischen Schichten mit einer Schichtdicke kleiner oder gleich 20 nm, vorzugsweise kleiner oder gleich 17 nm, vorzugsweise kleiner oder gleich 14 nm aufgebracht ist.

22. Verfahren nach einem der vorhergehenden Ansprüche, **dadurch gekennzeichnet, dass** zumindest eine der metallischen Schichten so aufgebracht wird, dass ihr spezifischer Widerstand, bezogen auf eine Schichtdicke von 12 nm, kleiner oder gleich 4,5 $\mu\Omega$cm, vorzugsweise kleiner oder gleich 4,2 $\mu\Omega$cm, vorzugsweise kleiner oder gleich 4,0 $\mu\Omega$cm ist.

23. Verfahren nach einem der vorhergehenden Ansprüche, **dadurch gekennzeichnet, dass** Blockerschichten aus $NbN_xO_y$ und/oder ZnO:Al und/oder $NiCrO_x$ aufgebracht werden.

24. Verfahren nach einem der vorhergehenden Ansprüche, **dadurch gekennzeichnet, dass** zumindest ein Sputter-Target mittels zumindest einer Bürste unter Beibehaltung des Vakuums gereinigt wird.

25. Verfahren nach dem vorhergehenden Anspruch, **dadurch gekennzeichnet, dass** zumindest eine der zumindest einen Bürsten eine Drahtbürste ist.

26. Wärmedämmendes und transparentes Schichtsystem mit einem transparenten Substrat, wobei das Substrat eine Oberfläche aufweist, auf welcher alternierend zumindest eine dielektrische Schicht und auf dieser zumindest eine metallische Schicht angeordnet sind, **dadurch gekennzeichnet, dass** zumindest eine der zumindest einen dielektrischen Schichten in einer relaxierten Kristallphase mit einer scharf definierten Vorzugsrichtung vorliegt, wobei die mittlere Fehlorientierung der Körner gegenüber der Vorzugsrichtung ≤ 4° ist.

27. Schichtsystem nach dem vorhergehenden Anspruch, **dadurch gekennzeichnet, dass** die mittlere Fehlorientierung der Körner gegenüber der Vorzugsrichtung ≤ 3° ist.

28. Schichtsystem nach einem der beiden vorhergehenden Ansprüche, **dadurch gekennzeichnet, dass** das Substrat transparent für sichtbares Licht ist.

29. Schichtsystem nach einem der Ansprüche 26 bis 28, **dadurch gekennzeichnet, dass** das Substrat Floatglas und/oder Einscheibensicherheitsglas aufweist oder daraus besteht.

30. Schichtsystem nach einem der Ansprüche 26 bis 29, **dadurch gekennzeichnet, dass** das Substrat gebogen ist.

31. Schichtsystem nach einem der Ansprüche 26 bis 30, **dadurch gekennzeichnet, dass** der Widerstand der zumindest einen metallischen Schicht, bezogen auf eine Schichtdicke von 12 nm, kleiner oder gleich 4,5 $\mu\Omega$cm, vorzugsweise kleiner gleich 4,2 $\mu\Omega$cm, vorzugsweise kleiner gleich 4,0 $\mu\Omega$cm ist.

32. Schichtsystem nach einem der Ansprüche 26 bis 31, **dadurch gekennzeichnet, dass** für die Reflexion und/oder die Transmission von elektromagnetischer Strahlung die durch einen Vorspannprozess und/oder eine thermische Nachbehandlung hervorgerufene Farbwertänderung $\Delta E:=(\Delta L^2+\Delta a^{*2}+\Delta b^{*2})^{1/2} < 3$, vorzugsweise $\Delta E < 2$ ist, wobei L, a* und b* Farbkoordinaten nach DIN 5033-3 sind.

33. Schichtsystem nach einem der Ansprüche 26 bis 32, **dadurch gekennzeichnet, dass** die transparente Scheibe durch ein Verfahren nach einem der Ansprüche 1 bis 27 hergestellt ist.

34. Verwendung eines Schichtsystems nach einem der Ansprüche 26 bis 33 als Scheibe, als Fensterscheibe, als Verglasung und/oder als Automobilverglasung.

## Claims

1. Method for manufacturing a heat-insulating and transparent layer system, at least one dielectric layer and at least one metallic layer being applied alternately on a transparent substrate,
   **characterised in that**
   the at least one dielectric layer is applied by means of high-power pulse sputtering, and
   **in that** at least one of the at least one dielectric layers is applied in a relaxed crystal phase with a sharply defined preferred direction,
   an average imperfect orientation of the particles relative to the preferred direction being ≤ 5°.

2. Method according to the preceding claim, **characterised in that** average imperfect orientation of the particles relative to the preferred direction is ≤ 4°, preferably ≤ 3°.

3. Method according to one of the preceding claims, **characterised in that** an infrared-reflecting layer is applied as at least one metallic layer.

4. Method according to one of the preceding claims, **characterised in that** at least one dielectric layer is applied by magnetron sputtering.

5. Method according to one of the preceding claims, **characterised in that** the sputtered material is applied with an ionisation degree of > 50%, preferably > 60%, preferably > 70%, preferably > 80%, preferably > 90%.

6. Method according to one of the preceding claims, **characterised in that** the sputtered material impinges on the layer system with an energy of more than 10 eV, preferably of more than 12 eV, preferably of more than 15 eV per particle.

7. Method according to one of the preceding claims, **characterised in that** the substrate is transparent and/or has float glass or consists thereof.

8. Method according to one of the preceding claims, **characterised in that** the substrate is prestressed before application of the layers and subsequently is cooled such that it is transformed into tempered safety glass.

9. Method according to the preceding claim, **characterised in that** the substrate is heated, for prestressing, to 600 to 700°C for a time of 5 to 15 min.

10. Method according to one of the two preceding claims, **characterised in that** the substrate is bent during the prestressing.

11. Method according to one of the three preceding claims, **characterised in that** the specific conductivity of the layer system, during prestressing, changes by less than 10%, preferably by less than 5%.

12. Method according to one of the preceding claims, **characterised in that** silver is applied during application of at least one of the at least one metallic layers.

13. Method according to one of the preceding claims, **characterised in that** zinc oxide is applied during application of at least one of the at least one dielectric layers.

14. Method according to one of the preceding claims, **characterised in that** at least one of the at least one dielectric layers is doped with a doping component.

15. Method according to the preceding claim, **characterised in that** the doping component is aluminium.

16. Method according to one of the preceding claims, **characterised in that** at least one of the at least one dielectric layers is sputtered reactively from a metallic zinc target.

17. Method according to the preceding claim, **characterised in that** the zinc target has a doping component.

18. Method according to one of the preceding claims, **characterised in that** at least one of the at least one dielectric layers is sputtered from a ceramic zinc oxide target.

19. Method according to the preceding claim, **characterised in that** the ceramic zinc oxide target has a doping component.

20. Method according to one of the preceding claims, **characterised in that** at least one of the at least one metallic layers is applied with a layer thickness of greater than or equal to 9 nm, preferably greater than or equal to 10 nm, preferably greater than or equal to 11 nm.

21. Method according to one of the preceding claims, **characterised in that** at least one of the at least one metallic layers is applied with a layer thickness of less than or equal to 20 nm, preferably less than or equal to 17 nm, preferably less than or equal to 14 nm.

22. Method according to one of the preceding claims, **characterised in that** at least one of the metallic layers is applied such that its specific resistance, relative to a layer thickness of 12 nm, is less than or equal to 4.5 $\mu\Omega$cm, preferably less than or equal to 4.2 $\mu\Omega$cm, preferably less than or equal to 4.0 $\mu\Omega$cm.

23. Method according to one of the preceding claims, **characterised in that** blocker layers made of $NbN_xO_y$ and/or ZnO:Al and/or $NiCrO_x$ are applied.

24. Method according to one of the preceding claims, **characterised in that** at least one sputter target is cleaned by means of at least one brush whilst maintaining the vacuum.

25. Method according to the preceding claim, **characterised in that** at least one of the at least one brushes is a wire brush.

26. Heat-insulating and transparent layer system having a transparent substrate, the substrate having a surface on which, alternately, at least one dielectric layer and on this at least one metallic layer are disposed, **characterised in that** at least one of the at least one dielectric layers is present in a relaxed crystal phase with a sharply defined preferred direction, the average imperfect orientation of the particles relative to the preferred direction being $\leq 4°$.

**27.** Layer system according to the preceding claim, **characterised in that** the average imperfect orientation of the particles relative to the preferred direction is $\leq 3°$.

**28.** Layer system according to one of the two preceding claims, **characterised in that** the substrate is transparent for visible light.

**29.** Layer system according to one of the claims 26 to 28, **characterised in that** the substrate has float glass and/or tempered safety glass or consists thereof.

**30.** Layer system according to one of the claims 26 to 29, **characterised in that** the substrate is bent.

**31.** Layer system according to one of the claims 26 to 30, **characterised in that** the resistance of the at least one metallic layer, relative to a layer thickness of 12 nm, is less than or equal to 4.5 $\mu\Omega$cm, preferably less than or equal to 4.2 $\mu\Omega$cm, preferably less than or equal to 4.0 $\mu\Omega$cm.

**32.** Layer system according to one of the claims 26 to 31, **characterised in that**, for the reflection and/or the transmission of electromagnetic radiation, the colour value change caused by a prestressing process and/or a thermal post-treatment is $\Delta E := (\Delta L^2 + \Delta a^{*2} + \Delta b^{*2})^{1/2} < 3$, preferably $\Delta E < 2$, L, a* and b* being colour coordinates according to DIN 5033-3.

**33.** Layer system according to one of the claims 26 to 32, **characterised in that** the transparent pane is produced by a method according to one of the claims 1 to 27.

**34.** Use of a layer system according to one of the claims 26 to 33, as a pane, as window pane, as glazing and/or as automobile glazing.

**Revendications**

**1.** Procédé de fabrication d'un système de couches thermo-isolant et transparent, dans lequel on applique en alternance sur un substrat transparent au moins une couche diélectrique et au moins une couche métallique,
**caractérisé en ce que**
la au moins une couche diélectrique est appliquée par pulvérisation cathodique pulsée à haute puissance, et au moins l'une des au moins une couche diélectrique est appliquée en phase cristalline relaxée dans une direction préférentielle nettement définie,
dans lequel une orientation erronée moyenne des grains par rapport à la direction préférentielle est $\leq 5°$.

**2.** Procédé selon la revendication précédente, **caractérisé en ce que** l'orientation erronée moyenne des grains par rapport à la direction préférentielle est $\leq 4°$, de préférence $\leq 3°$.

**3.** Procédé selon l'une quelconque des revendications précédentes, **caractérisé en ce que**, en tant que au moins une couche métallique, on applique une couche réfléchissant les infrarouges.

**4.** Procédé selon l'une quelconque des revendications précédentes, **caractérisé en ce qu'**au moins une couche diélectrique est appliquée par pulvérisation cathodique magnétron.

**5.** Procédé selon l'une quelconque des revendications précédentes, **caractérisé en ce que** le matériau pulvérisé est appliqué à un degré d'ionisation > 50 %, de préférence > 60 %, mieux encore > 70 %, bien mieux encore > 80 %, nettement mieux encore > 90 %.

**6.** Procédé selon l'une quelconque des revendications précédentes, **caractérisé en ce que** le matériau pulvérisé heurte le système de couches avec une énergie supérieure à 10 eV, de préférence supérieure à 12 eV, de préférence supérieure à 15 eV par particule.

**7.** Procédé selon l'une quelconque des revendications précédentes, **caractérisé en ce que** le substrat est transparent et/ou comporte du verre flotté ou en est constitué.

**8.** Procédé selon l'une quelconque des revendications précédentes, **caractérisé en ce que** le substrat est précontraint après l'application des couches, puis refroidi de sorte qu'il se transforme en verre de sécurité trempé.

9. Procédé selon la revendication précédente, **caractérisé en ce que** le substrat est chauffé à des fins de précontrainte pendant une période de temps de 5 à 15 min à 600 à 700 °C.

10. Procédé selon l'une quelconque des deux revendications précédentes, **caractérisé en ce que** le substrat est courbé pendant la précontrainte.

11. Procédé selon l'une quelconque des trois revendications précédentes, **caractérisé en ce que** la conductivité spécifique du système de couches varie lors de la précontrainte de moins de 10 %, de préférence de moins de 5 %.

12. Procédé selon l'une quelconque des revendications précédentes, **caractérisé en ce que**, lors de l'application d'au moins une de la au moins une des couches métalliques, on applique de l'argent.

13. Procédé selon l'une quelconque des revendications précédentes, **caractérisé en ce que**, lors de l'application d'au moins une de la au moins une des couches diélectriques, on applique de l'oxyde de zinc.

14. Procédé selon l'une quelconque des revendications précédentes, **caractérisé en ce qu'**au moins une de la au moins une des couches diélectriques est dopée avec un composant de dopage.

15. Procédé selon la revendication précédente, **caractérisé en ce que** le composant de dopage est l'aluminium.

16. Procédé selon l'une quelconque des revendications précédentes, **caractérisé en ce qu'**au moins une de la au moins une des couches diélectriques est pulvérisée de manière réactive par une cible de zinc métallique.

17. Procédé selon la revendication précédente, **caractérisé en ce que** la cible de zinc comporte un composant de dopage.

18. Procédé selon l'une quelconque des revendications précédentes, **caractérisé en ce qu'**au moins l'une des au moins une couche diélectrique est pulvérisée par une cible d'oxyde de zinc céramique.

19. Procédé selon la revendication précédente, **caractérisé en ce que** la cible d'oxyde de zinc céramique comporte un composant de dopage.

20. Procédé selon l'une quelconque des revendications précédentes, **caractérisé en ce qu'**au moins l'une des au moins une couche métallique est appliquée avec une épaisseur de couche supérieure ou égale à 9 nm, de préférence supérieure ou égale à 10 nm, mieux encore supérieure ou égale à 11 nm.

21. Procédé selon l'une quelconque des revendications précédentes, **caractérisé en ce qu'**au moins l'une des au moins une couche métallique est appliquée avec une épaisseur de couche inférieure ou égale à 20 nm, de préférence inférieure ou égale à 17 nm, mieux encore inférieure ou égale à 14 nm.

22. Procédé selon l'une quelconque des revendications précédentes, **caractérisé en ce qu'**au moins une des couches métalliques est appliquée de sorte que sa résistance spécifique, par rapport à une épaisseur de couche de 12 nm, soit inférieure ou égale à 4,5 $\mu\Omega$cm, de préférence inférieure ou égale à 4,2 $\mu\Omega$cm, mieux encore inférieure ou égale à 4,0 $\mu\Omega$cm.

23. Procédé selon l'une quelconque des revendications précédentes, **caractérisé en ce que** l'on applique des couches d'arrêt constituées de $NbN_xO_y$ et/ou de ZnO:Al et/ou de $NiCrO_x$.

24. Procédé selon l'une quelconque des revendications précédentes, **caractérisé en ce qu'**au moins une cible de pulvérisation cathodique est nettoyée au moyen d'au moins une brosse tout en maintenant le vide.

25. Procédé selon la revendication précédente, **caractérisé en ce qu'**au moins une des au moins une brosse est une brosse métallique.

26. Système de couches thermo-isolant et transparent avec un substrat transparent, dans lequel le substrat présente une surface, sur laquelle sont agencées en alternance au moins une couche diélectrique et, sur celle-ci, au moins une couche métallique, **caractérisé en ce qu'**au moins une de la au moins une des couches diélectriques est présente en phase cristalline relaxée dans une direction préférentielle nettement définie, l'orientation erronée moyenne des grains par rapport à la direction préférentielle étant ≤ 4°.

27. Système de couches selon la revendication précédente, **caractérisé en ce que** l'orientation erronée moyenne des grains par rapport à la direction préférentielle est ≤ 3°.

28. Système de couches selon l'une quelconque des deux revendications précédentes, **caractérisé en ce que** le substrat est transparent à la lumière visible.

29. Système de couches selon l'une quelconque des revendications 26 à 28, **caractérisé en ce que** le substrat comporte un verre flotté et/ou un verre de sécurité trempé ou en est constitué.

30. Système de couches selon l'une quelconque des revendications 26 à 29, **caractérisé en ce que** le substrat est courbé.

31. Système de couches selon l'une quelconque des revendications 26 à 30, **caractérisé en ce que** la résistance de la au moins une couche métallique, par rapport à une épaisseur de couche de 12 nm, est inférieure ou égale à 4,5 $\mu\Omega$cm, de préférence inférieure ou égale à 4,2 $\mu\Omega$cm, mieux encore inférieure ou égale à 4,0 $\mu\Omega$cm.

32. Système de couches selon l'une quelconque des revendications 26 à 31, **caractérisé en ce que**, pour la réflexion et/ou la transmission d'un rayonnement électromagnétique, la variation de valeur chromatique provoquée par un processus de précontrainte et/ou un post-traitement thermique $E := (\Delta L^2 + \Delta a^{*2} + \Delta b^{*2})^{1/2}$ est < 3, de préférence $\Delta E$ est < 2, où L, a* et b* sont les coordonnées chromatiques selon la norme DIN 5033-3.

33. Système de couches selon l'une quelconque des revendications 26 à 32, **caractérisé en ce que** la vitre transparente est fabriquée par un procédé selon l'une quelconque des revendications 1 à 27.

34. Utilisation d'un système de couches selon l'une quelconque des revendications 26 à 33 comme vitre, comme vitre de fenêtre, comme vitrage et/ou comme vitrage d'automobile.

Figur 1

Figur 2

Ladungsspannung $U_c = 800$ V

Figur 3

Figur 4

Figur 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005033769 A1
- EP 0636702 A1

- US 20060275612 A1

**In der Beschreibung aufgeführte Nicht-Patentliteratur**

- **VALDES, L.B.** Resistivity Measurements on Germanium for Transistors. *Proceedings of the IRE,* Februar 1954, 420-427
- **D.J. CHRISTIE et al.** Power Supply with Arc Handling for High-Peak Power Magnetron Sputtering. *J. Vac. Sci. Technol.,* 2004, vol. A22 (4), 1415-9
- **F. RUSKE ; A. PFLUG ; V. SITTINGER ; W. WERNER ; B. SZYSZKA ; D.J. CHRISTIE.** Reactive deposition of Al-doped ZnO thin films using high power pulsed magnetron sputtering (HPPMS. *Proceeding of the 6th ICCG,* 2006

- **CHRISTIE, D.J. ; TOMASEL, F. ; SPROUL, W.D. ; CARTER, D.C.** Power supply with arc handling for high peak power magnetron sputtering. *J: Va. Sci. Technol. A,* 2004, vol. 22 (4), 1415-9
- **CHRISTIE, D.J. ; PFLUG, A. ; SITTINGER, V. ; RUSKE, F. ; SIEMERS, M. ; SZYSZKA, B. ; GEISLER, M.** Model prediction and Empirical Conformation of Rate Scaling with Peak Power for High Power Pulse Magnetron Sputtering (HPPMS) Deposition of Thin Ag Films. *Proc. 48th SVC Tech. Conf.,* 2005, 501-3
- **F. RUSKE et al.** *Thin Solid Films,* 2007